(19) Europäisches Patentamt
European Patent Office
Office européen des brevets

(11) **EP 4 089 867 A1**

(12) **EUROPEAN PATENT APPLICATION**

(43) Date of publication:
**16.11.2022 Bulletin 2022/46**

(21) Application number: **22305708.4**

(22) Date of filing: **13.05.2022**

(51) International Patent Classification (IPC):
**H02H 7/00** *(2006.01)*      **H02H 9/04** *(2006.01)*

(52) Cooperative Patent Classification (CPC):
**H02H 9/042; H02H 7/008;** H02H 3/48

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.05.2021 CN 202110530172**

(71) Applicant: **Schneider Electric Industries SAS
92500 Rueil-Malmaison (FR)**

(72) Inventors:
• **XIAO, Peng
Shanghai, 201203 (CN)**

• **GAO, Jingxiang
Shanghai, 201203 (CN)**
• **LI, Xiaodong
Shanghai, 201203 (CN)**
• **TIAN, Simon
92500 Rueil-Malmaison (FR)**
• **MA, Feng
Shanghai, 201203 (CN)**

(74) Representative: **Manitz Finsterwald
Patent- und Rechtsanwaltspartnerschaft mbB
Martin-Greif-Strasse 1
80336 München (DE)**

(54) **METHOD AND ELECTRONIC APPARATUS FOR PREDICTING RESIDUAL LIFETIME OF VOLTAGE LIMITING ELEMENTS**

(57) Embodiments of the present disclosure relate to a method and electronic apparatus for predicting residual lifetime of a voltage limiting element. The method comprises: receiving current sensing signals representing currents flowing through a voltage limiting element within overvoltage period; determining, based on the current sensing signals, overvoltage parameter values of overvoltage parameters within the overvoltage period; and determining, based on a length of the overvoltage period and the overvoltage parameter values, residual lifetime of the voltage limiting element using an overvoltage model of voltage limiting element. The technical solutions in accordance with embodiments of the present disclosure enhance the precision for predicting residual lifetime of the voltage limiting element.

EP 4 089 867 A1

## Description

## FIELD

The present disclosure relates to the field of electronic devices, and more specifically, to a method, electronic apparatus, computer-readable storage medium and electronic device for predicting residual lifetime of the voltage limiting elements.

## BACKGROUND

To guard electronic devices against overvoltage-induced damage, electronic devices usually need to be provided with overvoltage protection function. Overvoltage often indicates surges over the line (such as thunder strike) or overvoltage of power supply systems. Surge protective device (SPD) is commonly used to protect other devices on the line against surge impacts. However, the vital element within the SPD, i.e., voltage limiting element, e.g., piezoresistor (including metal oxide varistor, MOV) and suppressor diode, would age by a certain degree after exposed to surges. When the aging of the voltage limiting element is built to a certain level, the SPD loses its protection power. At this time, the voltage limiting element should be replaced. In order to remind users to replace the voltage limiting element in time, it is required to predict aging or residual lifetime of the voltage limiting element.

The existing methods for predicting aging of voltage limiting elements usually are employed for surges. Surging currents tend to have a significant magnitude within a short time (measured in milliseconds). The current peak value is denoted in kA. However, these methods take no account of the effect on voltage limiting elements by overvoltage (e.g., power frequency overvoltage) of the power supply systems per se. Thus, the prediction result fails to truthfully reflect the residual lifetime of the voltage limiting elements.

Another method for predicting lifetime of voltage limiting elements is implemented by monitoring leak currents in the voltage limiting elements since the wear and tear of the voltage limiting elements are related to the leak currents. Such method puts a higher demand on test precision and entails a relatively complicated calculation.

## SUMMARY

Embodiments of the present disclosure provide method, electronic apparatus, computer-readable storage medium and electronic device for predicting residual lifetime of voltage limiting elements, to at least solve one of the above and other potential problems in the prior art.

In accordance with one aspect of the present disclosure, there is provided a method for predicting residual lifetime of a voltage limiting element. The method comprises: receiving current sensing signals; determining, based on the current sensing signals, overvoltage parameter values of overvoltage parameters within the overvoltage period; and determining, based on a length of the overvoltage period and the overvoltage parameter values, residual lifetime of the voltage limiting element using an overvoltage model of voltage limiting element. The current sensing signals represent currents flowing through a voltage limiting element within overvoltage period. Since the method predicts the residual lifetime of the voltage limiting element with the overvoltage model based on the current sensing signals and the overvoltage parameters, the residual lifetime of the voltage limiting element under various overvoltage conditions, including the power frequency overvoltage, can be accurately predicted.

In some implementations, the method also comprises: determining the overvoltage period based on sampling currents and threshold currents; and determining a length of the overvoltage period depending on a cycle of a sampling implemented on the current sensing signals during the overvoltage period and the number of sampling points. It is determined whether overvoltage occurs to the voltage limiting element depending on the sampling currents and the threshold currents. On this basis, the overvoltage period is determined. Besides, the length of the overvoltage period can be accurately determined in view of the sampling cycle and the number of sampling points.

In some implementations, the method also comprises: determining the overvoltage period based on a voltage across the voltage limiting element and a threshold voltage; and determining a length of the overvoltage period depending on a cycle of a sampling implemented on the current sensing signals during the overvoltage period and the number of sampling points. It is determined whether the voltage limiting element is switched on by comparing the overvoltage value with the threshold voltage. On this basis, the overvoltage period is determined. Furthermore, the length of the overvoltage period can be accurately determined in view of the sampling cycle and the number of sampling points.

In some implementations, determining a length of the overvoltage period includes: determining, based on the cycle of sampling, the number of sampling pints and values of sampling voltage, a length of a starting period of the overvoltage, a length of an intermediate period of the overvoltage, and a length of an end period of the overvoltage, wherein the starting period of the overvoltage is a first unit period containing a first overvoltage sampling point, and the end period of the overvoltage is a second unit period including a last overvoltage sampling point; and obtaining a length of the overvoltage period by adding a length of a starting period of the overvoltage, a length of an intermediate period of the overvoltage, and a length of an end period of the overvoltage. On account of the specific characteristics of the overvoltage waveform, the period of overvoltage is divided into starting period, intermediate period and end period, so as to accurately determine the length of the overvoltage period.

In some implementations, determining a length of a starting period of the overvoltage includes: determining whether the sampling voltage received exceeds a first threshold voltage; and determining a length of a time period from a moment corresponding to the sampling voltage to a moment where the first unit period ends as a length of the starting period if the sampling voltage exceeds the first threshold voltage, an absolute value of a difference between the sampling voltage and a previous sampling voltage exceeds a second threshold voltage, and an absolute value of the previous sampling voltage is smaller than an absolute value of the sampling voltage. It is determined whether voltage leap occurs by comparing the voltage sampling values with the predetermined thresholds and comparing the two adjacent sampling values. On this basis, the starting period of the overvoltage is determined.

In some implementations, determining the end period includes: determining whether a sampling voltage received exceeds a first threshold voltage; and determining a length of a time period from start of the second unit period to a moment corresponding to the sampling voltage as a length of the end period if the sampling voltage exceeds the first threshold voltage, an absolute value of a difference between the sampling voltage and a following sampling voltage exceeds a second threshold voltage, and an absolute value of the sampling voltage is greater than an absolute value of the following sampling voltage. It is determined whether voltage leap occurs by comparing the voltage sampling values with the predetermined thresholds and comparing the two adjacent sampling values. On this basis, the end period of the overvoltage is determined.

In some embodiments, determining a length of the intermediate period includes: determining whether a sampling voltage received exceeds a first threshold voltage; and determining a length of a time period when an absolute value of a difference between any two adjacent sampling voltages is below a second threshold as a length of the intermediate period if the sampling voltage exceeds the first threshold voltage. It is determined whether voltage leap occurs by comparing the voltage sampling values with the predetermined thresholds and comparing the two adjacent sampling values. Moreover, the time period where no leap occurs is determined as the intermediate period.

In some implementations, determining residual lifetime of the voltage limiting element using an overvoltage model of voltage limiting element includes: determining lifetime of the voltage limiting element using at least one of a first model representing an association between current peak values and lifetime of the voltage limiting element, a second model indicating an association between current effective values and lifetime of the voltage limiting element, a third model denoting an association between a first product and lifetime of the voltage limiting element, and a fourth model indicating an association between a second product and lifetime of the voltage limiting element, wherein the first product is a product of clamp voltage of the voltage limiting element and current peak values, and the second product is a product of current effective values and clamp voltage of the voltage limiting element. The residual lifetime of the voltage limiting element which experiences the overvoltage can be accurately predicted using the predetermined overvoltage model.

In some implementations, determining, based on the current sensing signals, overvoltage parameter values of overvoltage parameters within the overvoltage period includes: determining, based on the current sensing signals, current peak values, current effective values, a first product of clamp voltage and the current peak values, and a second product of the current effective values and the clamp voltage. As the above overvoltage parameters are conveniently acquired, the residual lifetime can be rapidly and accurately calculated.

In some implementations, determining, based on the current sensing signals, overvoltage parameter values of overvoltage parameters within the overvoltage period includes: determining a plurality of unit period overvoltage parameter values within a plurality of unit periods of the overvoltage period; and determining an average value of the plurality of unit period overvoltage parameter values corresponding to the plurality of unit periods as the overvoltage parameter value. The overvoltage condition during the overvoltage period can be more accurately reflected by determining overvoltage parameter values within a plurality of periods and further averaging these values. As a result, the overvoltage lifetime is accurately predicted.

In some implementations, determining, based on a length of the overvoltage period and the overvoltage parameter values, residual lifetime of the voltage limiting element using an overvoltage model of voltage limiting element includes: determining, based on a length of the overvoltage period and the overvoltage parameter values, overvoltage loss of the voltage limiting element; and determining, based on initial lifetime and the overvoltage loss, the residual lifetime of the voltage limiting element. Subsequent to determining the overvoltage loss within the overvoltage period, the residual lifetime of the voltage limiting element can be determined based on the initial lifetime.

In some implementations, determining, based on a length of the overvoltage period and the overvoltage parameter values, overvoltage loss of the voltage limiting element includes: determining, based on the current sensing signals, a plurality of unit overvoltage parameter values of the overvoltage parameters within a plurality of unit periods; determining, based on the plurality of unit overvoltage parameter values, a plurality of unit losses of the voltage limiting element within the plurality of unit periods using an overvoltage model of the voltage limiting element; and adding the plurality of unit losses to obtain the overvoltage loss. The loss within respective unit periods can be accurately determined by confirming a plurality of unit losses of the voltage limiting elements within a plurality of unit periods respectively. On this basis, the total overvoltage loss can be accurately determined.

In accordance with another aspect of the embodiments of the present disclosure, there is provided an electronic apparatus, comprising: a voltage limiting element; a measurement circuit configured to measure the voltage limiting element to obtain current sensing signals, the current sensing signals representing currents flowing through voltage limiting element within overvoltage period; and a processor configured to: receive the current sensing signals, determine, based on the current sensing signals, overvoltage parameter values of overvoltage parameters within the overvoltage period; and determine, based on a length of the overvoltage period and the overvoltage parameter values, residual lifetime of the voltage limiting element using an overvoltage model of voltage limiting element. By predicting the residual lifetime of the voltage limiting element, the electronic apparatus can indicate to the users the state of the voltage limiting element. Therefore, the users can replace the voltage limiting element in time before damage occurs.

In some implementations, the electronic apparatus also comprises: an AD converter configured to perform analog-to-digital conversion on the current sensing signals acquired by the measurement circuit. The AD converter is used to perform analog-to-digital conversion on the current sensing signals acquired by the measurement circuit, so as to enable the processor to process the current sensing signals. Therefore, the residual lifetime of the voltage limiting element is determined.

In some implementations, the electronic apparatus also comprises: a human-machine interface configured to indicate a state of the voltage limiting element based on residual lifetime of the voltage limiting element determined by the processor. With the aid of the human-machine interface, the electronic apparatus can intuitively interact with the users, dis play the state of the voltage limiting element in real time, or remind the users to replace the voltage limiting element in time.

In accordance with another aspect of the embodiments of the present disclosure, there is provided a computer-readable storage medium stored with computer programs, the programs, when executed by a processor, implementing any of the above methods.

In accordance with a further aspect of the embodiments of the present disclosure, there is provided an electronic device, comprising: a processor; a memory stored with processor-executable instructions, the instructions, when executed by the processor, causing the electronic device to perform any of the above methods.

Through the following description, it will be understood that the method for predicting residual lifetime of the voltage limiting element implemented by the present disclosure can more accurately predict the residual lifetime of the voltage limiting elements, apply to line overvoltage situations, and broaden the application range of the existing methods for predicting residual lifetime of the voltage limiting element.

The Summary is to introduce a selection of concepts in a simplified form that are further described below in the Detailed Description. This Summary is not intended to identify key features or essential features of the present disclosure, nor is it intended to be used to limit the scope of the present disclosure.

## BRIEF DESCRIPTION OF THE DRAWINGS

Fig. 1 illustrates a schematic block diagram of an electronic apparatus in accordance with some example embodiments of the present disclosure;

Fig. 2 illustrates a flowchart for a method of predicting the residual lifetime of the voltage limiting element in accordance with some example embodiments of the present disclosure;

Fig. 3 illustrates a schematic diagram of a fitted curve indicating an association between overvoltage parameters and lifetime of the voltage limiting element in accordance with some example embodiments of the present disclosure;

Fig. 4 illustrates a schematic diagram of waveforms of overvoltage test in accordance with some example embodiments of the present disclosure; and

Fig. 5 illustrates a schematic diagram of a processor in accordance with some example embodiments of the present disclosure.

In each drawing, same or corresponding reference signs indicate same or corresponding composites.

## DETAILED DESCRIPTION OF EMBODIMENTS

Principles of the present disclosure are now explained with reference to various example embodiments shown in the drawings. It should be appreciated that description of those embodiments is merely to enable those skilled in the art to better understand and further implement the present disclosure and is not intended for limiting the scope disclosed herein in any manners. It should be noted similar or same reference signs can be used in the drawings where feasible, and similar or same reference signs can represent similar or same functions. Those skilled in the art will easily understand from the following description that alternative embodiments of the structure and/or method described in the text can be adopted without deviating from the principles of the present invention described herein

As used herein, the term "includes" and its variants are to be read as open-ended terms that mean "includes, but is not limited to." Unless the context clearly indicates otherwise, the term "or" is to be read as "and/or". The term "based on" is to be read as "based at least in part on." The terms "one example embodiment" and "one embodiment" are to be read as "at least one example embodiment." The term "a further embodiment" is to be read as "at least a further embodiment." The terms "first", "second" and so on can refer to same of different objects.

Voltage limiting elements exhibit high impedance when no surges are present, but the impedance continues to decrease as the surge currents and voltage grow. Common voltage limiting elements include piezo-resistors and suppressor diodes. As mentioned above, it is already known that a method for predicting aging of the voltage limiting elements takes no account of the effect of overvoltage of the power supply system itself on the voltage limiting elements. In such case, the prediction result could not truthfully reflect the actual residual lifetime of the voltage limiting elements. Another method for predicting the lifetime of the voltage limiting element is carried out by monitoring leak currents in the voltage limiting elements. However, this method puts higher demands on test precision and entails a relatively complicated calculation.

Embodiments of the present disclosure propose an improved electronic apparatus and a method for predicting residual lifetime of a voltage limiting element. In some embodiments of the present disclosure, the residual lifetime of the voltage limiting element is determined through an overvoltage model by obtaining relevant overvoltage parameters of the voltage limiting element, such as peak current. The overvoltage model, for example, may be built on the basis of numerous tests to indicate a relation between lifetime and overvoltage parameters of voltage limiting elements. Besides, the overvoltage model may be pre-stored in a memory of the electronic apparatus or acquired in real time from a cloud via network communications. The overvoltage model may either be a profile representing a relation between the lifetime and the overvoltage parameters of the voltage limiting elements, or a corresponding look-up table. The residual lifetime of the voltage limiting element may be calculated in the overvoltage model according to the values of the received overvoltage parameters.

The method for predicting the lifetime of the voltage limiting elements according to the embodiments of the present disclosure can quantify lifetime loss of the voltage limiting elements under multiple overvoltage states including power frequency overvoltage, so as to accurately and rapidly predict the residual lifetime of the voltage limiting elements.

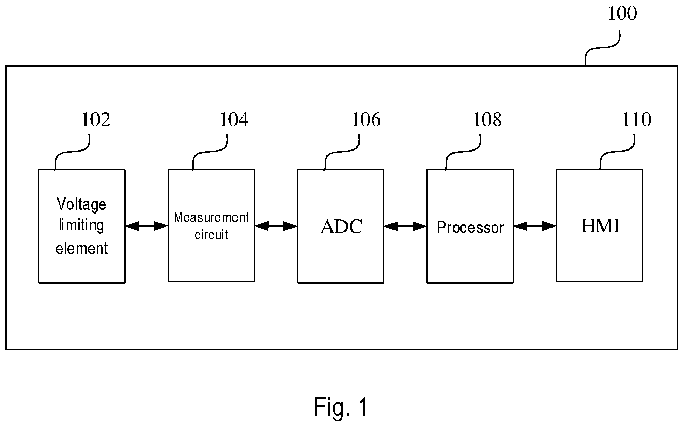

Technical solutions in accordance with example embodiments of the present disclosure are explained in details below with reference to Figs. 1 to 5. Fig. 1 illustrates a schematic diagram of an electronic apparatus 100 in accordance with embodiments of the present disclosure. The electronic apparatus 100 includes voltage limiting elements 102, a measurement circuit 104, an ADC 106, a processor 108 and a Human-Machine Interface (HMI) 110. In some embodiments, the voltage limiting elements 102 may be piezo-resistor, such as metal oxide varistor. In some embodiments, the voltage limiting elements 102 may be suppressor diode. The voltage limiting elements 102 are usually parallel connected in the circuit, e.g., between power line and ground line in parallel with load. If a circuit runs normally, the voltage applied across the voltage limiting element 102 is lower than a threshold voltage of the voltage limiting element. Accordingly, impedance of the voltage limiting element 102 is quite high and the leak current is small in the voltage limiting element. In such case, the circuit is considered as open. Once the voltage across the voltage limiting element 102 reaches the threshold voltage, the voltage limiting element 102 is switched on. By now, the impedance in the voltage limiting element 102 decreases rapidly, such that large currents may flow through the voltage limiting elements 102 to bypass the currents for the load under protection.

The measurement circuit 104 tests the voltage limiting elements 102, to collect the relevant overvoltage parameters to be described below. The ADC 106 preforms AD conversion on the output of the measurement circuit 104. In other words, analog signals collected by the measurement circuit 104 are converted into digital ones, which are further provided to the processor 108 for processing. In the embodiment shown by Fig. 1, the ADC 106 and the measurement circuit 104 are separated, but the embodiments of the present disclosure are not limited to this. Alternatively, the ADC 106 may also be integrated with the measurement circuit 104.

The processor 108 receives current sensing signals and determines, based on these current sensing signals, values of the overvoltage parameters in the period of overvoltage. Besides, the processor 108 determines the residual lifetime of the voltage limiting elements 102 by means of the overvoltage model of the voltage limiting elements based on the length of the overvoltage period and the overvoltage parameter values. The electronic apparatus 100 also includes HMI 110, e.g., indicator. The indicator, for example, may be LED or buzzer. When the lifetime of the voltage limiting elements 102 is about to end, the HMI 110 reminds users to change the voltage limiting elements 102 in time. The HMI 110 also may be a button, through which the users for example may switch on or off the electronic apparatus 100. HMI 110 is not limited to the aforementioned indicator, button and the like, and may also be other components that can enable human-machine interactions. The structure of the electronic apparatus 100 shown in Fig. 1 is only schematic, and embodiments of the present disclosure may have various modifications, rather than being limited to the above specific structure.

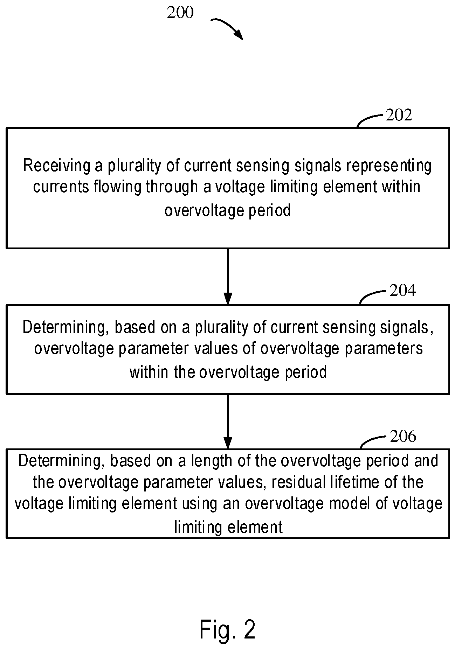

Fig. 2 illustrates a flowchart for a method of predicting residual lifetime of voltage limiting elements in accordance with embodiments of the present disclosure.

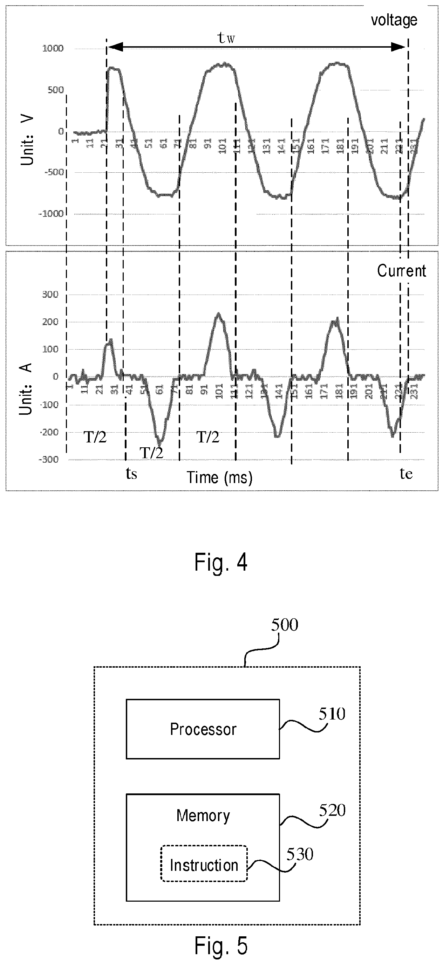

It is to be understood that the method 200 also may include additional acts not shown and/or omit the already illustrated acts. The scope of the present disclosure is not restricted in this regard. The method 200 may be executed by an electronic apparatus 100 in Fig. 1 and an electronic device 800 in Fig. 5. As such, a variety of aspects described for the electronic apparatus 100 and the electronic device 800 may be applicable to the method 200.

At 202, a processor of the electronic apparatus 100 receives current sensing signals representing currents flowing through the voltage limiting element 102 in the period of overvoltage. In some embodiments, current sensing signals may be acquired by the measurement circuit 104 from sampling the currents flowing through the voltage limiting elements 102. In some embodiments, the measurement circuit 104 includes a current sensor, a voltage sensor and a transformer etc., to directly or indirectly measure the currents flowing through the voltage limiting elements 102. The current sensing signals may be regular current/voltage signals with periodicity or irregular current/voltage signals.

Values of overvoltage parameters within the overvoltage period are determined at 204 based on the current sensing signals. In some embodiments, the overvoltage parameters may include at least one of: peak value Ipeak and effective value Irms of currents flowing through the voltage limiting elements 102, a product of current peak value Ipeak and clamp voltage Uv, and a product of current effective value Irms and clamp voltage Uv. The current peak value Ipeak indicates a value of the current waveform with the maximum absolute value at peak or trough. The current effective value Irms is a root mean square, which indicates that a DC current and an AC current respectively pass a resistor of the same resistance. If the heat produced by the two currents passing the resistor within the same period of time is the same, the value of the DC current is then considered as the effective value of the AC current. The clamp voltage Uv may also be known as ON threshold voltage. Once a voltage exceeds the clamp voltage Uv, the voltage limiting elements 102 switch from OFF state to ON state. For each voltage limiting element 102, the clamp voltage Uv is a fixed value. Values of the above overvoltage parameters, i.e., overvoltage parameter values, can be determined by processing a plurality of currents or voltage sensing signals. In the above embodiments, despite the overvoltage is periodic or aperiodic, more than one peak waveforms appear in the overvoltage period, and the peak waveform (likewise current effective value) is associated with the lifetime of the voltage limiting elements 102. The acquisition of the above overvoltage parameters is relatively simple. With the acquired overvoltage parameters, preparations have been made for subsequent calculations based on the overvoltage model.

In some embodiments, a plurality of unit period overvoltage parameter value within a plurality of unit periods of the period of overvoltage is determined in the first place. The unit period may be half of the cycle of line voltage, i.e., T/2, where T indicates the cycle of the voltage over the line. In other words, the overvoltage parameter values within each T/2 are determined, such as Ipeak, or Irms, or product of Ipeak/Irms and Uv. Afterwards, an average value of the plurality of unit period overvoltage parameter values corresponding to a plurality of unit periods is determined as overvoltage parameter value. That is, an average value of the overvoltage parameter values within respective T/2 is determined as the overvoltage parameter value. In the above embodiments, the unit period is set to be half of the cycle of the line voltage, such that each T/2 of the period of overvoltage includes a corresponding peak current Ipeak. Thus, a peak current Ipeak may be determined for each unit period. By averaging the overvoltage parameter values within a plurality of periods of time, the overvoltage condition in the period of overvoltage can be more accurately reflected. As a result, the overvoltage lifetime may be accurately predicted.

In some embodiments, the method also includes: determining a period of overvoltage based on sampling currents and threshold currents. Currents and threshold currents are sampled at a predetermined frequency, e.g., of hundreds, or thousands or tens of thousands of Hz, and the multiple sampled values are compared with the corresponding predetermined overvoltage thresholds, to determine whether an overvoltage occurs to the voltage limiting elements 102. The period of overvoltage is subsequently determined. For example, upon detecting a current signal exceeding the predetermined threshold current, it is determined that the voltage limiting element 102 is already in an overvoltage state. The period of overvoltage may also be determined by specifying the starting point and the end point of the overvoltage state. Besides, a length of the period of overvoltage may be determined based on the cycle of the sampling carried out on the current sensing signals within the period of overvoltage and the number of sampling points included. For instance, if the sampling cycle is Ts and M sampling points in total are used within the period of overvoltage, the length of the period of overvoltage is Ts*M.

Alternatively, the period of overvoltage may also be determined according to the voltage across the voltage limiting elements 102 and the threshold voltage. For example, by comparing the voltage across the voltage limiting elements 102 with the threshold voltage, a determination is made as to whether the voltage limiting elements 102 are in ON state. The period of overvoltage may be determined based on the initial ON time and the final OFF time of the voltage limiting elements 102 within the same period. In other words, a time period between the sampling point at which the voltage begins to exceed the threshold voltage during the overvoltage and the last sampling point at which the voltage is above the threshold voltage during the overvoltage is determined as the period of overvoltage. As such, it is determined whether the voltage limiting element 102 is conducted by comparing the sampled voltage values with the threshold voltage, to further determine the period of the overvoltage. Subsequently, a length of the period of the overvoltage is determined based on the sampling cycle and the number of sampling points.

In some further embodiments, the length of the period of overvoltage may also be determined based on the cycle of the sampling implemented on the current sensing signals during the period of overvoltage and the number of sampling points included. For example, a comparison may be made between the sampling currents and the predetermined current thresholds. If the sampling current is greater than the predetermined current threshold, it is determined that the voltage limiting element 102 is in ON state. The initial ON time and the OFF time of the voltage limiting element 102 within the period of overvoltage are determined by current values. On this basis, the period of overvoltage may further be determined. Knowing the sampling cycle and the total number of sampling points within the overvoltage period, the period may be obtained by multiplying the above two.

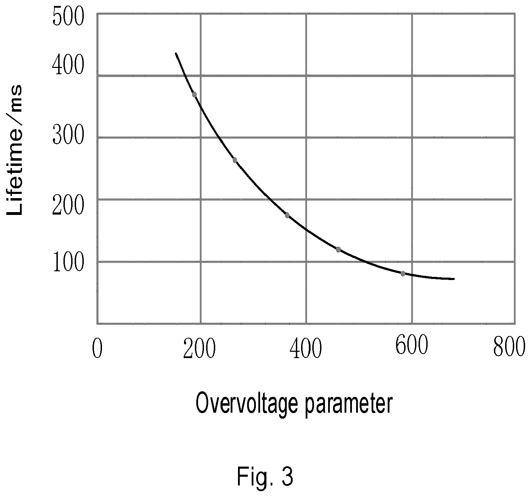

The method for obtaining an overvoltage model of the voltage limiting element 102 is depicted below with reference to Figs. 3 to 4. The overvoltage model of the voltage limiting element denotes an association between the lifetime of the voltage limiting element 102 and the overvoltage parameter. The overvoltage model may be obtained by measuring corresponding relations between overvoltage parameters and lifetime for a plurality of voltage limiting elements respectively and by fitting. For example, it is assumed that a plurality of voltage limiting elements manufactured by the same process has basically the same lifetime. Some voltage limiting elements are selected randomly from the plurality of voltage limiting elements and further tested for their respective overvoltage parameters, so as to obtain an overvoltage model for the plurality of voltage limiting elements. The overvoltage model may be pre-stored in a memory of an electronic apparatus or at cloud, to assist the electronic apparatus in subsequent prediction of residual lifetime.

In order to predict the lifetime of the voltage limiting element in overvoltage state, the relation between the lifetime of the voltage limiting element and the voltage and current in case of overvoltage should be specified. In some embodiments of the present invention, experimental approaches are adopted to obtain the relation between the lifetime of the voltage limiting element and the voltage and current in case of overvoltage.

In some embodiments, an overvoltage, i.e., a voltage exceeding the ON voltage threshold of the voltage limiting elements, is applied across the voltage limiting elements during a test for voltage limiting elements. If the applied overvoltage is not direct current, the overvoltage here indicates that the voltage applied within a predetermined period of time includes voltage above the ON voltage threshold. However, it is not dictated that the voltage value is above the ON voltage threshold at every time point. Then, a total tolerance time of the voltage limiting element is measured. Accordingly, the total tolerance time of the voltage limiting element under various voltage and current conditions is obtained through this method. The association between the related overvoltage parameter and the lifetime of the voltage limiting element is subsequently acquired by curve fitting.

In some embodiments, the applied voltage is acquired by boosting the power frequency voltage (220V, 50Hz), such as 800V, 750V and 650V etc. It is to be pointed out that the voltages listed here are only exemplary and the present disclosure is not limited to those values.

For example, test currents (prospective short-circuit currents) in voltage limiting elements are determined first according to the different overvoltage values applied. The prospective short-circuit currents indicate the currents flowing through the voltage limiting elements when they are short-circuited. For the voltage limiting elements of the same specification, the corresponding test currents may also vary even when the same overvoltage is applied. This is because the circuit is serially connected with resistors with varying resistance during the test of the voltage limiting elements. As a result, the prospective short-circuit currents may differ in the test circuit when the same overvoltage is applied.

In some embodiments, if an overvoltage is applied across the voltage limiting elements, tolerance time and Ipeak (peak current)/Irms (current effective value) may be measured in the voltage limiting element. Accordingly, Uv*Ipeak and Irms*Uv may be calculated, where Uv denotes clamp voltage of the voltage limiting element, also referred to as ON threshold voltage. In addition, the tolerance time represents a period of time lasting from the initial conduction to the failure of the voltage limiting element under the act of the voltage.

Accordingly, in the above embodiments, the overvoltage is applied to conduct the voltage limiting element, so as to determine its lifetime. Overvoltage parameters (Ipeak, Irms, Uv*Ipeak and Irms*Uv) and the tolerance time are recorded. Then, a plurality of voltage limiting element samples is tested, to generate a fitted curve indicating an association between the overvoltage parameter and the tolerance time. A functional relation therebetween is further determined based on the fitted curve.

In some embodiments, multiple current peak values may exist during the overvoltage. At this time, the absolute values of all Ipeak may be averaged to be the Ipeak of the overvoltage period, thereby obtaining the fitted curve.

Explanations are provided in the above embodiments with an example of the fitted curve that generates the association therebetween. Technical solutions in accordance with the embodiments of the present disclosure are not limited to the above. Instead, they may vary in different ways. For example, a corresponding table may be generated based on the tested overvoltage parameters and tolerance time. In the table, the specific overvoltage parameters and the corresponding tolerance time are written. The fitted curve and the table may be stored in the memory of the electronic apparatus or at cloud for use.

Fig. 3 schematically illustrates a diagram of a fitted curve indicating an association between the overvoltage parameter and the lifetime of the voltage limiting element. As shown, the longitudinal coordinate is lifetime in milliseconds (ms) and the horizontal coordinate is overvoltage parameter, which may be one of Ipeak, Irms, Ipeak*Uv and Irms*Uv. Corresponding overvoltage parameters may be selected according to the actual needs, to further obtain the above association.

The fitted curve representing the association between the longitudinal coordinate and the horizontal coordinate may be obtained based on a plurality of test points. In some embodiments, the fitted curve may be automatically generated via software in view of the above multiple test points, or it may be calculated manually according to a predetermined algorithm based on the above multiple test points. The fitted curve is one of the above overvoltage models.

As mentioned above, Uv is the clamp voltage of the voltage limiting element, i.e., ON threshold voltage. Uv is a fixed value for each voltage limiting element. However, the value may deviate by ±10% depending on individual differences. With individual difference in consideration, the product of Ipeak*Uv may act as the horizontal coordinate, to determine an association with the longitudinal coordinate (lifetime).

In the fitted curve of Fig. 3, the fitting relationship can always reflect lifetime characteristics of the voltage limiting element under overvoltage no matter which overvoltage parameter serves as the horizontal coordinates, but the precision may vary. A curve with the best degree of fitting may be selected as the basis for lifetime prediction, where the fitting degree may be determined by various test values and proximity of the fitted curve.

For instance, in some embodiments, a relation between lifetime and Ipeak is selected as the basis for lifetime prediction:

$$lifetime = F(Ipeak)$$

The above formula indicates that the lifetime of the voltage limiting element is a function of Ipeak. The specific expression of the function F may vary for voltage limiting elements of different specifications and may be obtained through tests.

Similarly, Function lifetime=F(Ipeak*Uv), or lifetime=F(Irms) or lifetime=F(Irms*Uv) may also be selected depending on the actual situations.

The method for obtaining the overvoltage model of the voltage limiting element has been explained above with reference to Fig. 3. However, the method for obtaining the overvoltage model of the voltage limiting element according to embodiments of the present disclosure is not limited to the above overvoltage parameters. Instead, other overvoltage parameters may also be employed.

It should be understood that numerical values described here and at other places of the text are provided for descriptive and exemplary purposes only, and are not intended for restricting the scope of the present disclosure. Any other values are also feasible. Besides, the method shown here is exemplary only. Embodiments of the present disclosure may have various modifications and are not limited to the specific method disclosed here.

The above embodiments are explained mainly by an example of the overvoltage similar to power frequency voltage. However, solutions in accordance with embodiments of the present disclosure are not limited to the amplitude and frequency of the overvoltage listed in the above embodiments. Other amplitude values and frequencies are also available. Apparently, the overvoltage waveform is also not limited to sine wave. Instead, it may be any other shapes of waveforms including irregular waveforms.

In some embodiments of the present disclosure, the overvoltage parameters are explained by examples of Ipeak, Irms, Uv*Ipeak and Irms*Uv. However, the overvoltage parameters in the embodiments of the present disclosure are not limited to Ipeak, Irms, Uv*Ipeak and Irms*Uv. Other values may also be adopted, such as a product of Ipeak and width of current pulse etc.

In addition to the overvoltage prediction of power supply systems, solutions in accordance with embodiments of the present disclosure may also be adapted to prediction of surges in varying embodiments. As stated above, surge current is characterized by short time in milliseconds and large currents, and its peak value is measured in kA. In some embodiments of the present disclosure, a higher sampling frequency may also be used to achieve the same effect of predicting residual lifetime of voltage limiting elements under overvoltage including surges.

Reference is drawn from Fig. 4 to further explain how the length of the period of overvoltage is determined below. Fig. 4 illustrates a schematic diagram of waveform of an overvoltage test in accordance with embodiments of the present disclosure. As shown, the upper portion is voltage waveform while the lower portion demonstrates corresponding current waveform. In Fig. 4, the horizontal coordinate is time in ms, and the upper portion of the longitudinal coordinate is V, and the lower portion of the longitudinal coordinate is A. It is demonstrated in Fig. 4 that the horizontal coordinate (i.e., time) is divided into multiple unit time. In this embodiment, the unit time is T/2, where T represents the overvoltage frequency, such as 50Hz, 60Hz, 100Hz and 1000Hz etc. Clearly, the above frequency values are only exemplary and embodiments of the present disclosure are not limited to the overvoltage of the above frequency. The overvoltage at any frequency may also be used. Besides the overvoltage having a periodic frequency, embodiments of the present invention is also adapted to overvoltage with aperiodic frequency.

In some embodiments, considering that voltage leap may exist at the beginning and the end of the overvoltage, the overvoltage time at the leap could not be calculated by a general method for situations without leap. According to the general method for situations without leap, the overvoltage time is calculated simply by multiplying the sampling cycle Ts by the number N of sampling points within each unit period. By contrast, in the unit period where voltage leap occurs, the overvoltage waveform fails to fully occupy the unit period. As such, the number of sampling points does not reach N, and the overvoltage time could not be calculated directly based on Ts*N. To solve this problem, the voltage waveform is divided, based on its shape, into three parts: wave head (starting period), middle wave (intermediate period) and wave tail (end period) in some embodiments of the present disclosure as shown in Fig. 4. The wave head represents the waveform of the overvoltage within the first unit period, e.g., waveform within the first T/2; the wave tail indicates the waveform of the overvoltage within the last unit period, such as the waveform within the last T/2; and the middle wave is a regular waveform of the overvoltage between the wave head and the wave tail.

In some embodiments, length is determined respectively for wave head, middle wave and wave tail. The above lengths are then added to obtain the length of the period of overvoltage. The lengths of wave head, middle wave and wave tail are separately determined as follows: the length of the starting period of the overvoltage, the length of the intermediate period of the overvoltage and the length of the end period of the overvoltage are determined based on sampling cycle, the number of sampling points and sampled voltage values. The starting period of the overvoltage is the first unit period including the first overvoltage sampling point, i.e., the aforementioned first T/2 shown in Fig. 4. The end period of the overvoltage refers to the second unit period containing the last overvoltage sampling point, i.e., the overvoltage waveform within the last T/2 illustrated in Fig. 4. The middle wave is a period of time between the two. When the wave head, middle wave and wave tail are determined, the length of the period of overvoltage is obtained by adding the length of the starting period of overvoltage, the length of the intermediate period of overvoltage and the length of the end period of overvoltage. The first overvoltage sampling point represents the first overvoltage point collected when overvoltage just begins, e.g., the sampling point pointed by the arrow left to tw in Fig. 4. The last overvoltage sampling point denotes the last sampling point collected right before the end of overvoltage, e.g., the sampling point indicated by the arrow right to tw in Fig. 4.

In the above embodiments, on account of the specific characteristics of the voltage waveform, the period of overvoltage is divided into starting period, intermediate period and end period. The three periods are calculated separately. Because the method has already considered the scenario where the length of the period of wave head and wave tail may be less than the unit period (i.e., T/2), the specific leap position and the sampling point corresponding to the position may be accurately determined. On this basis, the periods of wave head and wave tail are accurately calculated in view of the sampling cycle Ts, so is the period of overvoltage as a whole.

In some embodiments, the time tw of a single overvoltage may be calculated depending on the voltage waveform. For example, the ON time and the OFF time of the voltage limiting element 102 may be determined through voltage waveform. On this basis, the ON period of the voltage limiting element 102, i.e., period of overvoltage, may also be determined. The length of the period of overvoltage is then calculated based on the sampling cycle Ts and the total number of sampling points.

In some embodiments, the length of the starting period of the overvoltage is determined as follows: a determination is made as to whether the received sampling voltage exceeds a first threshold voltage. For example, the first threshold voltage is the ON threshold voltage of the voltage limiting element 102. If the sampling voltage exceeds the first threshold voltage, it indicates the presence of overvoltage. In the case that the sampling voltage exceeds the first threshold voltage, it is determined whether an absolute value of a difference between the sampling voltage and the previous sampling voltage is greater than a second threshold voltage, where the second threshold voltage may be smaller than the first threshold voltage, but is definitely greater than a given predetermined value. If yes, it indicates that voltage leap occurs here, and the voltage leap may be in wave head or wave tail period. To further distinguish the voltage leap, it is determined whether an absolute value of the previous sampling voltage is smaller than the absolute value of the sampling voltage. If yes, it is determined that the voltage leap is in the period of wave head, i.e., starting time. Consequently, a length of the time period from the moment corresponding to the sampling voltage to the moment where the first unit period ends is determined as the length of the starting period.

In other words, the wave head may be confirmed by: determining whether there is a sampling point with voltage exceeding Uv; determining whether a leap exists in voltage values of two adjacent sampling points, i.e., satisfying the condition that abs(U(i+1)-U(i))>U_THRESHOLD (meaning the voltage values at the two adjacent sampling points are greater than a predetermined threshold); and determining whether an absolute value of the voltage at a pre-leap sampling point is smaller than an absolute value of the voltage at a post-leap sampling point, i.e., satisfying the condition of abs(U(i))<abs(U(I+1)), where i is an integer greater than 0.

If the results of the above determinations are all yes, a length of a time period from a moment corresponding to the first sampling voltage to a moment where the first unit period ends is determined as the length of the starting period. As shown in Fig. 4, a time period from a time point when the voltage leap occurs (the moment indicated by the arrow left to tw) within the first unit period to a moment ts where the first unit period ends is determined as the starting period of the overvoltage.

In the above embodiments, it is determined whether voltage leap occurs by comparing the voltage sampling value with the predetermined threshold and comparing the two adjacent sampling values. On this basis, the starting period of the overvoltage is determined.

In some embodiments, the end period is determined as follows: a determination is made as to whether the received sampling voltage exceeds the first threshold voltage. As stated above, if the sampling voltage exceeds the first threshold voltage, it indicates the presence of overvoltage. Then, it is determined whether an absolute value of a difference between the sampling voltage and a following sampling voltage exceeds a second threshold voltage. The first and second threshold voltages described here are the same as the previously mentioned ones. If the result of the determination is yes, it indicates that voltage leap occurs here, and the voltage leap may be in wave head or wave tail period. To further distinguish the voltage leap, it is determined whether an absolute value of the sampling voltage is greater than the absolute value of the following sampling voltage. If yes, it is determined that the voltage leap is in the period of wave tail, i.e., end period. Consequently, a length of the time period from the start of the second unit period to the moment corresponding to the sampling voltage is determined as the length of the end period. According to Fig. 4, a time period from a starting moment te of the second unit period within the second unit period (T/2 in the far right) to a time point where voltage leap occurs (the moment indicated by arrow right to tw) is determined as the end period of overvoltage.

In other words, the wave tail may be confirmed by: determining where there is a sampling point with voltage exceeding Uv; determining whether a leap exists in voltage values of two adjacent sampling points, i.e., satisfying the condition that abs(U(i+1)-U(i))>U_THRESHOLD (meaning that an absolute value of a difference between the voltage values at the two adjacent sampling points is greater than a predetermined threshold); and determining whether an absolute value of the voltage at a pre-leap sampling point is greater than an absolute value of the voltage at a post-leap sampling point, i.e., satisfying the condition of abs(U(i))<abs(U(i+1)).

If the results of the above determinations are all yes, a length of a time period starting from a moment where the second unit period begins to a moment corresponding to the sampling voltage is determined as the length of the end period.

In the above embodiments, it is determined whether voltage leap occurs by comparing the voltage sampling value with the predetermined threshold and comparing the two adjacent sampling values. On this basis, the end period of the overvoltage is determined.

In some embodiments, the middle period is determined as follows: a determination is made as to whether the received sampling voltage exceeds the first threshold voltage, wherein the first threshold voltage may be ON threshold voltage of the voltage limiting element 102. If the sampling voltage exceeds the first threshold voltage, it indicates the presence of overvoltage. In the case that the sampling voltage exceeds the first threshold voltage, it is determined whether an absolute value of a difference between any two adjacent sampling voltages is below the second threshold, the second threshold being a clamp potential of the voltage limiting element 102. The first and second threshold voltages described here are the same as the previously mentioned ones. If the result of the determination is yes, it indicates that no voltage leap occurs within this time period, and the length of the time period is determined as the length of intermediate period.

In other words, the middle wave is confirmed by: determining whether there are voltage sampling points having a voltage above Uv; determining whether leap exists between voltage values at two adjacent sampling points. If the results of the above determinations are all yes, the current unit period is determined as the intermediate period.

In the above embodiments, it is determined whether voltage leap occurs by comparing the voltage sampling value with the predetermined threshold and comparing the two adjacent sampling values. On this basis, the intermediate period of the overvoltage is determined.

In some embodiments, for overvoltage in the intermediate period, the length of the unit period may be calculated by multiplying the sampling cycle Ts by the number N of sampling points within the unit period. Furthermore, the total length of the intermediate period of the overvoltage may be determined based on the number of the unit periods. For example, if there are L unit periods, the intermediate period has a length of Ts*N*L.

In some embodiments, for overvoltage in the starting period, the length of the starting period of the overvoltage may be determined depending on the sampling cycle Ts and the number of sampling points within the first unit period after the first overvoltage sampling point. For instance, if the first overvoltage sampling point is the i-th sampling point within T/2, there are N-i sampling points within the first unit period after the first overvoltage sampling point. Therefore, the length of the starting period is Ts*(N-i).

In some embodiments, the length of the end period of the overvoltage may be determined by the sampling cycle Ts and the number of sampling points within the second unit period before the last overvoltage sampling point. For example, when the last overvoltage sampling point is the i-th sampling point within T/2, there are i sampling points within the second unit period before the last overvoltage sampling point. Accordingly, the length of the end period is Ts*i.

Voltage and current waveforms shown in Fig. 4 are just exemplary waveforms of overvoltage of the voltage limiting element in some embodiments of the present disclosure. Apparently, the overvoltage waveforms of the voltage limiting element in accordance with embodiments of the present disclosure are not limited to the above shape and amplitude. Instead, different variations are also acceptable. Besides, the above approach for selecting the unit period is also not limited to the method described in the above embodiments. In other words, it is possible that the unit period is selected in other ways.

At 206, residual lifetime of the voltage limiting element 102 is determined using the overvoltage model of the voltage limiting element 102 based on the length of the overvoltage period and the overvoltage parameters.

In some embodiments, the residual lifetime of the voltage limiting element 102 may be determined via one of: a first model indicating an association between the current peak and the lifetime of the voltage limiting element 102, the first model, for example, being a fitted curve embodying a relation between Ipeak and lifetime of the voltage limiting element 102; a second model representing an association between current effective value and lifetime of voltage limiting element 102, the second model, for example, being a fitted curve reflecting a relation between Irms and lifetime of voltage limiting element 102; a third model indicating an association between a first product and lifetime of the voltage limiting element 102, the third model, for example, being a fitted curve reflecting a relation between the first product and the lifetime of the voltage limiting element 102; and a fourth model representing a second product and lifetime of the voltage limiting element 102, the fourth model, for example, being a fitted curve embodying a relation between the second product and the lifetime of the voltage limiting element 102. The first product is a product of the clamp voltage of the voltage limiting element 102 and the current peak value, and the second product is a product of the current effective value and the clamp voltage of the voltage limiting element 102. The overvoltage model may be either a curve reflecting a relation between the lifetime of the voltage limiting element 102 and the overvoltage parameters, or a corresponding data table. In some embodiments, the overvoltage model may be determined by experimental means as stated above. In some embodiments, the residual lifetime of the voltage limiting element 102 which has experienced the overvoltage can be accurately predicted using the predetermined overvoltage model. The above model is exemplary only, and the overvoltage model in accordance with embodiments of the present disclosure is not limited to the above described ones.

In some embodiments, determining, based on the current sensing signals, one of: current peak value Ipeak, current effective value Irms, first product of clamp voltage Uv and current peak value Ipeak, and second product of current effective value Irms and clamp voltage Uv during the overvoltage period. In the above embodiments, the overvoltage parameters can be conveniently acquired, which facilitates calculations of residual lifetime and simplifies the prediction procedure.

In some embodiments, a plurality of unit period overvoltage parameter values within a plurality of unit periods of the period of overvoltage is determined. The unit period may be half of the cycle of line voltage, i.e., T/2, as stated above, where T indicates the cycle of the voltage over the line. An average value of the plurality of unit period overvoltage parameter values corresponding to a plurality of unit periods is determined as overvoltage parameter value. For example, the Ipeak within each T/2 is first determined and then all of the Ipeak in each T/2 is averaged to indicate the Ipeak within the overvoltage period. In the above embodiments, by averaging the overvoltage parameter values within a plurality of periods of time, the overvoltage condition in the period of overvoltage can be accurately reflected. As a result, the overvoltage lifetime may be accurately predicted as well.

In some embodiments, overvoltage loss of the voltage limiting element 102 may be determined based on the length of the overvoltage period and the overvoltage parameter values. After the length of the overvoltage period and the overvoltage parameter values are determined, the lifetime loss (i.e., overvoltage loss) within the overvoltage period may be calculated using the overvoltage model. The overvoltage loss may be relative values of the loss, i.e., percentage value, or may be absolute values, such as specific loss time. Afterwards, the residual lifetime of the voltage limiting element 102 may be determined based on the initial lifetime and the overvoltage loss. The residual lifetime may be a relative value, i.e., residual percentage value produced by deducting the loss percentage from the one hundred percent. The residual lifetime may also be an absolute value. That is, the absolute residual lifetime is obtained by the initial lifetime minus the loss lifetime. In the above embodiments, when the overvoltage loss within the period of overvoltage is determined, the residual lifetime of the voltage limiting element 102 which experiences the overvoltage can be calculated in view of the initial lifetime.

In some embodiments, a plurality of unit overvoltage parameter values of the overvoltage parameters within a plurality of unit periods are determined based on the current sensing signals. For instance, Ipeak*Uv within each T/2 is determined. Based on the plurality of unit overvoltage parameter values, multiple unit losses of the voltage limiting element 102 within a plurality of unit periods are respectively determined using the overvoltage model of the voltage limiting element 102. In other words, the lifetime of the voltage limiting element 102 within the T/2 is predicted by means of the overvoltage model. On this basis, the lifetime loss of the voltage limiting element 102 within the T/2, i.e., unit loss, may be determined. The total overvoltage loss is obtained by adding a plurality of unit losses. In the above embodiments, the respective unit loss of the voltage limiting element 102 within a plurality of unit periods is determined separately, so as to accurately calculate the total overvoltage loss.

In the following text, it is described how the residual lifetime of the voltage limiting element 102 is determined using the overvoltage model of the voltage limiting element 102 based on the length of the overvoltage period and the overvoltage parameter values.

In some embodiments, based on the current waveform, an expected tolerance time (lifetime) of the voltage limiting element 102 under such current characteristics can be calculated. First of all, the length of the overvoltage period can be determined through the current waveform. As mentioned above, the sampling current may be compared with the predetermined current threshold. When the sampling current is greater than the predetermined current threshold, it is determined that the voltage limiting element 102 is in ON state. In addition, the time when the voltage limiting element 102 is initially switched on and finally switched off within this period is determined via current values. On this basis, the overvoltage period is also determined. Moreover, the expected lifetime within the overvoltage period, i.e., expected tolerance time, may be determined using the overvoltage model based on the length of the overvoltage period and the overvoltage parameters, such as Ipeak and Irms etc.

In some embodiments, after a single overvoltage, the lifetime loss of the voltage limiting element 102 is calculated by tw/Life-time, where tw represents length of a single overvoltage period, and Life-time indicates the expected tolerance time within the overvoltage period.

In some embodiments, for periodic overvoltage, each T/2 has one Ipeak, and each Ipeak may be different. In such case, the lifetime loss is calculated every T/2 based on the following formulae:

$$L1 = t1/F(I_{peak1}),$$

$$L2 = t2/F(I_{peak2}),$$

$$...$$

$$Ln = tn/F(I_{peakn}).$$

Where t1, t2 ... tn is overvoltage time within the unit period. That is, for periodic voltage waveforms, the middle overvoltage time (t2 ... tn-1) is the same, i.e., T/2, apart from the waveforms at two ends. F(I_{peaki}) represents a functional relation between the expected lifetime within the i-th period and the peak currents within the same period. The functional relation may be obtained by the method described above with reference to Figs. 3 to 4.

In this embodiment, the lifetime loss of the voltage limiting element 102 caused by the overvoltage may be obtained by adding the loss within the above unit periods, i.e., Ls=L1+L2...+Ln. Therefore, the residual lifetime in the embodiment is: 100%-Ls.

The above embodiments take Ipeak as an example for explanation. Apparently, overvoltage parameters of the embodiments of the present disclosure are not limited to Ipeak. Further, other previously mentioned overvoltage parameters may also be used. In the above embodiments, Ipeak of respective T/2 period is calculated separately, and the corresponding lifetime loss is also calculated. Embodiments of the present disclosure are not limited to the above approach. In some further embodiments, the absolute values of each Ipeak are averaged as the Ipeak of this overvoltage, to further calculate the lifetime loss. The detailed procedure is not illustrated here.

Fig. 5 illustrates a schematic diagram of a processor in accordance with embodiments of the present disclosure.

As shown in Fig. 5, the electronic device 500 includes a processor 510 that controls operations and functions of the electronic device 500. For example, in some example embodiments, the processor 510 may execute various operations by means of the instructions 530 stored in a memory 520 coupled to the processor. The memory 520 may be of any suitable types adapted to local technical environments, and may be implemented using any suitable data storage technologies, including but not limited to, semiconductor-based storage devices, magnetic storage devices and systems, optical storage devices and systems. Although Fig. 5 only illustrates one memory cell, it is possible that the electronic device 500 may contain a plurality of memory cells that are physically distinct.

The processor 510 may be of any suitable types adapted to local technical environments, including but not limited to, one or more of general purpose computers, dedicated computers, microcontrollers, digital signal controller (DSP) and controller-based multicore controller architecture. The electronic device 500 also may include a plurality of processors 510, which may be coupled to the communication unit (not shown). The communication unit may receive and transmit the information through radio signals or by means of optic fibers, cables and/or other components.

In accordance with embodiments of the present disclosure, there is also provided a computer-readable storage medium with computer programs stored thereon, wherein the programs, when executed by the processor, implement the above method of the embodiments of the present disclosure.

Besides, in accordance with embodiments of the present disclosure, there is further provided an electronic device, including a processor and a memory stored with processor-executable instructions, the instructions, when executed by the processor, causing the electronic device to perform the above methods.

The voltage limiting element described in the above embodiments may be piezo-resistor or suppressor diode. A typical example of the piezo-resistor may be metal oxide varistor. It is certain that the embodiments described with piezo-resistor and suppressor diode as the example are preferred embodiments of the present disclosure. However, the voltage limiting element is not limited to piezo-resistor and suppressor diode. The technical solution of the embodiments of the present disclosure is also applicable to other voltage limiting element.

Various embodiments of the present disclosure have been described above and the described embodiments are optional embodiments of the present disclosure. The above description is only exemplary rather than exhaustive and is not limited to the embodiments of the present disclosure. Although the claims of the present application are drafted for specific combinations of the features, it should be understood that the scope of the present disclosure also includes explicit or implicit features, or any novel features or any novel combinations of the features, no matter whether the features relate to the same solution in any claims or not. Applicant hereby states that new claims may be drafted for these features and/or combinations thereof in the examination procedure of the present application or any further applications derived from the present application.

The selection of terms in the text aims to best explain principles and actual applications of each embodiment and technical improvements made in the market by each embodiment, or enable those ordinary skilled in the art to understand embodiments of the present disclosure. Many modifications and alterations of the present disclosure are obvious for those skilled in the art. Any modifications, equivalent substitutions and improvements shall be included in the protection scope of the present disclosure as long as they are within the spirit and principle disclosed herein.

**List of Reference Numerals:**

Fig. 1

102: voltage limiting element
104: measurement circuit
108: processor

Fig. 2

202: receiving a plurality of current sensing signals representing currents flowing through a voltage limiting element within overvoltage period;
204: determining, based on a plurality of current sensing signals, overvoltage parameter values of overvoltage parameters within the overvoltage period;

206: determining, based on a length of the overvoltage period and the overvoltage parameter values, residual lifetime of the voltage limiting element using an overvoltage model of voltage limiting element

Fig. 3

Lifetime
Overvoltage parameter

Fig. 4

Unit
Current
Time (ms)
voltage

Fig. 5

510: processor
520: memory
530: instruction

**Claims**

1. A method for predicting residual lifetime of a voltage limiting element, comprising:

   receiving current sensing signals representing currents flowing through the voltage limiting element during overvoltage period;
   determining, based on the current sensing signals, overvoltage parameter values of overvoltage parameters during the overvoltage period;
   determining, based on a length of the overvoltage period and the overvoltage parameter values, residual lifetime of the voltage limiting element using an overvoltage model of voltage limiting element.

2. The method of claim 1, further comprising:

   determining the overvoltage period based on sampling currents and threshold currents; and determining a length of the overvoltage period based on a cycle of a sampling implemented on the current sensing signals during the overvoltage period and the number of sampling points.

3. The method of claim 1, further comprising:

   determining the overvoltage period based on a voltage across the voltage limiting element and a threshold voltage; and determining a length of the overvoltage period based on a cycle of a sampling implemented on the current sensing signals during the overvoltage period and the number of sampling points.

4. The method of claim 3, wherein determining the length of the overvoltage period includes:

    determining, based on the cycle of sampling, the number of sampling points and values of sampling voltage, a length of a starting period of the overvoltage, a length of an intermediate period of the overvoltage, and a length of an end period of the overvoltage, wherein the starting period of the overvoltage is a first unit period containing a first overvoltage sampling point, and the end period of the overvoltage is a second unit period including a last overvoltage sampling point; and
    obtaining a length of the overvoltage period by adding a length of a starting period of the overvoltage, a length of an intermediate period of the overvoltage, and a length of an end period of the overvoltage.

5. The method of claim 4, wherein determining the length of a starting period of the overvoltage includes:

    determining whether the sampling voltage received exceeds a first threshold voltage; and
    determining a length of a time period from a moment corresponding to the sampling voltage to a moment where the first unit period ends as a length of the starting period if the sampling voltage exceeds the first threshold voltage, an absolute value of a difference between the sampling voltage and a previous sampling voltage exceeds a second threshold voltage, and an absolute value of the previous sampling voltage is smaller than an absolute value of the sampling voltage.

6. The method of claim 4, wherein determining the end period includes:

    determining whether a sampling voltage received exceeds a first threshold voltage; and
    determining a length of a time period from start of the second unit period to a moment corresponding to the sampling voltage as a length of the end period if the sampling voltage exceeds the first threshold voltage, an absolute value of a difference between the sampling voltage and a following sampling voltage exceeds a second threshold voltage, and an absolute value of the sampling voltage is greater than an absolute value of the following sampling voltage.

7. The method of claim 4, wherein determining the length of the intermediate period includes:

determining whether a sampling voltage received exceeds a first threshold voltage; and determining a length of a time period when an absolute value of a difference between any two adjacent sampling voltages is below a second threshold as a length of the intermediate period if the sampling voltage exceeds the first threshold voltage.

8. The method of any of the preceding claims, wherein determining the residual lifetime of the voltage limiting element using the overvoltage model of voltage limiting element includes:
    determining lifetime of the voltage limiting element using at least one of a first model representing an association between current peak values and lifetime of the voltage limiting element, a second model representing an association between current effective values and lifetime of the voltage limiting element, a third model representing an association between a first product and lifetime of the voltage limiting element, and a fourth model representing an association between a second product and lifetime of the voltage limiting element, wherein the first product is a product of clamp voltage of the voltage limiting element and current peak values, and the second product is a product of current effective values and clamp voltage of the voltage limiting element.

9. The method of any of the preceding claims, wherein determining, based on the current sensing signals, the overvoltage parameter values of the overvoltage parameters during the overvoltage period includes:
    determining, based on the current sensing signals, current peak values, current effective values, a first product of clamp voltage and the current peak values, and a second product of the current effective values and the clamp voltage during the overvoltage period.

10. The method of any of the preceding claims, wherein determining, based on the current sensing signals, the overvoltage parameter values of the overvoltage parameters during the overvoltage period includes:

    determining a plurality of unit period overvoltage parameter values during a plurality of unit periods of the overvoltage period; and
    determining an average value of the plurality of unit period overvoltage parameter values corresponding to the plurality of unit periods as the overvoltage parameter value.

11. The method of any of the preceding claims, wherein determining, based on the length of the overvoltage period and the overvoltage parameter values, the residual lifetime of the voltage limiting element using the overvoltage model of voltage limiting element includes:

determining, based on the length of the overvoltage period and the overvoltage parameter values, overvoltage loss of the voltage limiting element; and
determining, based on initial lifetime and the overvoltage loss, the residual lifetime of the voltage limiting element.

12. The method of claim 11, wherein determining, based on the length of the overvoltage period and the overvoltage parameter values, the overvoltage loss of the voltage limiting element includes:

determining, based on the current sensing signals, a plurality of unit overvoltage parameter values of the overvoltage parameters during a plurality of unit periods;
determining, based on the plurality of unit overvoltage parameter values, a plurality of unit losses of the voltage limiting element during the plurality of unit periods using the overvoltage model of the voltage limiting element, respectively; and
adding the plurality of unit losses to obtain the overvoltage loss.

13. An electronic apparatus, comprising:

a voltage limiting element;
a measurement circuit configured to measure the voltage limiting element to obtain current sensing signals, the current sensing signals representing currents flowing through voltage limiting element during overvoltage period; and
a processor configured to: receive the current sensing signals, determine, based on the current sensing signals, overvoltage parameter values of overvoltage parameters during the overvoltage period; and determine, based on a length of the overvoltage period and the overvoltage parameter values, residual lifetime of the voltage limiting element using an overvoltage model of voltage limiting element.

14. The electronic apparatus of claim 13, further comprising:
an AD converter configured to perform analog-to-digital conversion on the current sensing signals obtained by the measurement circuit.

15. The electronic apparatus of claim 13 or 14, further comprising:
a human-machine interface configured to indicate a state of the voltage limiting element based on the residual lifetime of the voltage limiting element determined by the processor.

16. A computer-readable storage medium stored with computer programs, the programs, when executed by a processor, implementing the method of any of claims 1-12.

17. An electronic device, comprising:

a processor;
a memory stored with processor-executable instructions, the instructions, when executed by the processor, causing the electronic device to perform the method of any of claims 1-12.

100

102 104 106 108 110

| Voltage limiting element | ⟷ | Measurement circuit | ⟷ | ADC | ⟷ | Processor | ⟷ | HMI |

Fig. 1

200

202

Receiving a plurality of current sensing signals representing currents flowing through a voltage limiting element within overvoltage period

204

Determining, based on a plurality of current sensing signals, overvoltage parameter values of overvoltage parameters within the overvoltage period

206

Determining, based on a length of the overvoltage period and the overvoltage parameter values, residual lifetime of the voltage limiting element using an overvoltage model of voltage limiting element

Fig. 2

Fig. 3

Fig. 4

Fig. 5

Europäisches
Patentamt
European
Patent Office
Office européen
des brevets

# EUROPEAN SEARCH REPORT

Application Number

EP 22 30 5708

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 217 502 A1 (SCHNEIDER ELECTRIC IND SAS [FR]) 13 September 2017 (2017-09-13) <br> * abstract * <br> * figures 2, 7-8 * <br> * paragraph [0002] * <br> * paragraph [0011] – paragraph [0026] * <br> * paragraph [0034] * <br> * figures 2, 4-6 * | 1-17 | INV. <br> H02H7/00 <br> H02H9/04 |
| X | US 2016/161547 A1 (FARQUHAR III LOUIS A [US] ET AL) 9 June 2016 (2016-06-09) <br> * abstract; figures 2, 4-6 * <br> * paragraph [0003] * <br> * paragraph [0021] – paragraph [0023] * | 1-17 | |
| A | CN 110 907 713 A (SCHNEIDER ELECTRIC IND SAS) 24 March 2020 (2020-03-24) <br> * abstract * <br> * figures 1-2 * | 1-17 | |

| | TECHNICAL FIELDS SEARCHED (IPC) |
|---|---|
| | H02H |

The present search report has been drawn up for all claims

| Place of search | Date of completion of the search | Examiner |
|---|---|---|
| Munich | 28 September 2022 | Operti, Antonio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

**ANNEX TO THE EUROPEAN SEARCH REPORT**

**ON EUROPEAN PATENT APPLICATION NO.** EP 22 30 5708

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2022

| Patent document cited in search report | | Publication date | Patent family member(s) | | Publication date |
|---|---|---|---|---|---|
| EP 3217502 | A1 | 13-09-2017 | EP 3217502 | A1 | 13-09-2017 |
| | | | ES 2890976 | T3 | 25-01-2022 |
| US 2016161547 | A1 | 09-06-2016 | CN 105699800 | A | 22-06-2016 |
| | | | US 2016161547 | A1 | 09-06-2016 |
| CN 110907713 | A | 24-03-2020 | NONE | | |

EPO FORM P0459

For more details about this annex : see Official Journal of the European Patent Office, No. 12/82